# EUROPEAN PATENT APPLICATION

(11) **EP 4 657 707 A1**
(43) Date of publication of application: **03.12.2025**
(21) Application number: 25171831.8
(22) Date of filing: 23.04.2025
(51) Int. Cl.: H02J 7/00, H01M 10/42

(54) **BATTERY PACK AND OPERATING METHOD THEREOF**

(30) Priority: 29.05.2024 KR 20240070294
(71) Applicant: LG Electronics Inc., Yeongdeungpo-gu Seoul 07336 (KR)
(72) Inventor: CHUNG, Deokyong, 07336 Seoul (KR)
(74) Representative: Vossius & Partner Patentanwälte Rechtsanwälte mbB

(57) **Abstract**

The present disclosure provides a battery pack (100) capable of normal release of an over-discharge prevention mode and an operating method thereof. When it is determined that an over-discharge condition is satisfied, the battery pack is controlled to the over-discharge prevention mode, and when operating in the over-discharge prevention mode, if a preset over-discharge prevention release condition is satisfied, it is possible to re-determine whether the battery module (110) satisfies an over-discharge condition and determine whether to release the over-discharge prevention mode.

## Description

### BACKGROUND OF THE INVENTION

### 1.Field of the Invention

The present disclosure relates to a battery pack and an operating method thereof.

### 2. Discussion of the Related Art

Batteries are essential for electronic devices such as smartphones, laptops, and portable TVs. Recently, lithium-ion batteries are widely used as batteries for these electronic devices.

Lithium-ion batteries are lightweight and have high energy density relative to their weight. However, if these lithium-ion batteries are over-discharged, the molecular structure of the battery's cathode material may be damaged. In other words, problems such as shortened battery life may occur due to over-discharge.

Over-discharge refers to a situation in which the battery is discharged too much and falls below the normal minimum voltage level. Over-discharge occurs due to various causes. For example, over-discharge occurs due to long-term use of the device, failure of the battery management system, long-term natural discharge, etc.

Therefore, circuits and algorithms are being developed to prevent over-discharge. For example, a method to prevent over-discharge can be implemented by providing a discharging switch between the battery module and a charger and an over-discharge prevention mode that turns off the discharging switch when completely discharged. However, in this case, if the discharging switch is turned off due to an error in measuring a battery voltage even though it is not in a completely discharged state, a problem occurs in which the over-discharge prevention mode cannot be released. In other words, since the over-discharge prevention mode is not released, the battery cannot be used, and the user recognizes that there is battery power remaining, but a symptom occurs in which the power is turned off when the charging adapter is removed. In other words, a problem occurs in which the over-discharge prevention mode is not released even when the charging adapter is connected.

### SUMMARY OF THE INVENTION

The present disclosure seeks to solve the above-described problems.

The present disclosure seeks to provide a battery pack capable of normally releasing an over-discharge prevention mode and an operating method thereof.

The present disclosure seeks to provide a battery pack capable of releasing an over-discharge prevention mode when there is no over-discharge condition and an operating method thereof.

The present disclosure seeks to provide a battery pack capable of solving a battery charging failure problem caused by an over-discharge prevention mode and an operating method thereof.

A battery pack according to an embodiment of the present disclosure comprising a battery module including at least one battery cell, a charging switch connected to the battery module, a discharging switch connected to the charging switch, and a BMS configured to control the charging switch and the discharging switch, wherein the BMS is configured to control the battery module in an over-discharge prevention mode when it is determined that the battery module satisfies an over-discharge condition, and when a preset over-discharge prevention release condition is satisfied while operating in the over-discharge prevention mode, re-determine whether the battery module satisfies an over-discharge condition and determine whether to release the over-discharge prevention mode.

The BMS can release the over-discharge prevention mode if the over-discharge condition is not satisfied as a result of the re-determination.

The BMS can release the over-discharge prevention mode even if a charger is not connected if the over-discharge condition is not satisfied as a result of the re-determination.

The BMS can determine that the over-discharge prevention release condition is satisfied when a voltage of the battery module exceeds a predetermined voltage.

The BMS can determine that the over-discharge prevention release condition is satisfied if an output voltage from a charger connected to the battery pack is less than a battery voltage of the battery module.

The BMS can determine that the over-discharge prevention release condition is satisfied if a voltage applied to the battery module is less than a battery voltage of the battery module.

The BMS can determine that the over-discharge prevention release condition is satisfied if an output voltage from the charger connected to the battery pack and a voltage applied to the battery module are different.

The BMS can determine that the over-discharge prevention release condition is satisfied when no charging current flows to the battery module.

The BMS can control the discharging switch to off when operating in the over-discharge prevention mode and control the discharging switch to on when releasing the over-discharge prevention mode.

The BMS can determine that the over-discharge condition is not satisfied when a voltage of the battery module exceeds a predetermined voltage.

An operating method according to an embodiment of the present disclosure comprising operating a battery module in a normal mode in which it is charged or discharged, controlling the battery module to an over-discharge prevention mode when it is determined that the battery module satisfies an over-discharge condition, re-determining whether the battery module satisfies an over-discharge condition when a preset over-discharge prevention release condition is satisfied while operating in the over-discharge prevention mode, and determining whether to release the over-discharge prevention mode based on a result of the re-determination.

The operating method can further comprise releasing the over-discharge prevention mode if the over-discharge condition is not satisfied as a result of the re-determination.

The releasing the over-discharge prevention mode can comprise releasing the over-discharge prevention mode even if a charger is not connected if the over-discharge condition is not satisfied as a result of the re-determination.

The over-discharge prevention release condition can include at least one of: when a voltage of the battery module exceeds a predetermined voltage, when an output voltage from a charger connected to the battery pack is less than a voltage of the battery module, when a voltage applied to the battery module is less than the voltage of the battery module, when an output voltage from a charger connected to the battery pack and the voltage applied to the battery module are different and when no charging current flows to the battery module.

The operating method can further comprise determining that the over-discharge condition is not satisfied when a voltage of the battery module exceeds a predetermined voltage as a result of the re-determination.

According to the embodiment of the present disclosure, since the over-discharge prevention mode is normally released when it is not an over-discharge state, there is a technical effect of minimizing malfunction problems such as charging failure.

According to the embodiment of the present disclosure, there is an advantage of improving operational reliability by releasing the over-discharge prevention mode when it enters the over-discharge prevention mode even when it is not an actual over-discharge state.

### BRIEF DESCRIPTION OF THE DRAWINGS

FIG. 1 is a diagram illustrating a battery pack according to an embodiment of the present disclosure.
FIG. 2 is a diagram illustrating a battery pack according to an embodiment of the present disclosure operating in a normal mode.
FIG. 3 is a diagram illustrating a battery pack according to an embodiment of the present disclosure operating in an over-discharge prevention mode.
FIG. 4 is a diagram illustrating a voltage relationship for explaining an above-described problem.
FIG. 5 is a flowchart illustrating an operating method of a battery pack according to a first embodiment of the present disclosure.
FIG. 6 is a flowchart illustrating an operating method a battery pack according to a second embodiment of the present disclosure.
FIG. 7 is a flowchart illustrating step S60 of FIG. 6.

### DETAILED DESCRIPTION OF THE PREFERRED EMBODIMENTS

Hereinafter, embodiments related to the present disclosure will be described in more detail with reference to the drawings.

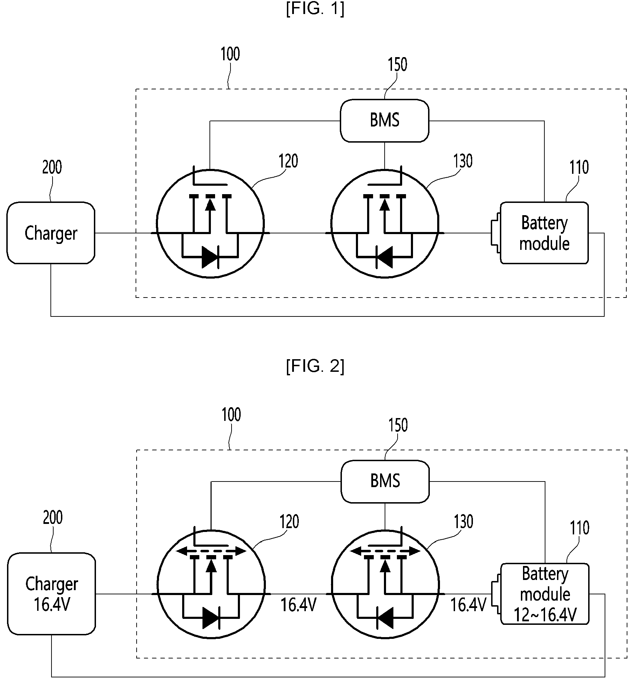

FIG. 1 is a drawing illustrating a battery pack according to an embodiment of the present disclosure.

The battery pack 100 can be mounted on an electronic device such as a smartphone, a laptop, or a mobile TV.

When the electronic device is not connected to an external power source, the battery pack 100 can supply the voltage required for the operation of the electronic device. That is, the voltage charged in the battery pack 100 can be discharged while the electronic device is not connected to the external power source.

When the electronic device is connected to the external power source, the battery pack 100 can be charged. Specifically, the battery pack 100 can be connected to a charger 200, and the charger 200 can be connected to an adapter (not shown) of the electronic device. When the electronic device is connected to the external power source through the adapter (not shown), the external power can be supplied to the battery pack 100 as well as the electronic device. The battery pack 100 can be charged by receiving external power. That is, the battery pack 100 can be charged while the electronic device is connected to the external power source.

The charger 200 can be connected to the battery pack 100. The charger 200 can supply the external power to the battery pack 100 while the adapter is connected to the external power source. In FIG. 1, the charger 200 is described as a part of the electronic device, but the charger 200 may also be a part of the battery pack 100.

The battery pack 100 can include at least one of a battery module 110, a discharging switch 120, a charging switch 130, and a BMS 150.

The battery module 110 may include at least one battery cell. The battery module 110 may be configured in a form in which multiple battery cells are connected. The battery cell is the most basic unit that contains basic elements such as a cathode, anode, a separator, and an electrolyte. The battery module 110 may be configured by gathering multiple battery cells as described above. In other words, the battery module 110 may be configured by bundling multiple battery cells. The number of battery cells configuring the battery module 110 may vary.

The voltage of the battery module 110 may vary depending on a type of battery cell and the number of battery cells. For example, if the voltage of the battery cell is 3.0 to 4.1 V and four of these battery cells are connected to configure the battery module 110, the voltage of the battery module 110 may be 12.0 to 16.4 V. Here, 12.0 V may be a discharge voltage and 16.4 V may be a full-charge voltage. Over-discharge may mean that the voltage of battery module 110 is below the discharge voltage of 12.0 V.

The discharging switch 120 is a switch to prevent the over-discharge of the battery module 110. The discharging switch 120 can cut off the output of the battery module 110.

The over-discharge can mean a situation where the voltage is discharged too much and falls below the normal minimum voltage level. The over-discharge can lead to problems such as performance degradation or reduced lifespan.

The battery pack 100 can be equipped with a discharging switch 120 to prevent the over-discharge. The discharging switch 120 can be placed on a power line connecting the battery module 110 and the charger 200. In addition, a charging switch 130 can be additionally placed on a power line connecting the battery module 110 and the charger 200.

The discharging switch 120 and the charging switch 130 can each be a MOSFET (Metal-Oxide-Semiconductor Field Effect Transistor). The discharging switch 120 and the charging switch 130 may be connected in series.

The battery pack 100 may be provided with the charging switch 130 to prevent overcharging. The charging switch 130 may be placed on a power line connecting the battery module 110 and the charger 200. The charging switch 130 may be connected to the battery module 110. The charging switch 130 may be connected to the discharging switch 130.

The discharging switch 120 and the charging switch 130 may be placed on a power line connecting the battery module 110 and the charger 200. The discharging switch 120 may be placed closer to the charger 200 among the charger 200 and the battery module 110. The charging switch 130 may be placed closer to the battery module 110 among the charger 200 and the battery module 110. The discharging switch 120 may be placed between the charger 200 and the charging switch 130, and the charging switch 130 may be placed between the discharging switch 120 and the battery module 110.

The discharging switch 120 may be turned off if the battery module 110 is in an over-discharge condition. The discharging switch 120 may be turned on if the battery module 110 is not in the over-discharge condition.

The BMS (150, Battery Management System) can control the operation of battery pack 100. The BMS 150 can diagnose and control the status of battery pack 100. The BMS 150 can detect or control the status of at least one of the battery module 110, the discharging switch 120, and the charging switch 130.

The BMS 150 can detect voltage and/or current of a power line connecting the charger 200 and the battery module 110. In addition, the BMS 150 can detect voltage of the battery module 110.

The BMS 150 can determine whether an over-discharge condition occurs. The BMS 150 can control the battery pack 100 to the over-discharge prevention mode when it determines that battery module 110 satisfies the over-discharge condition.

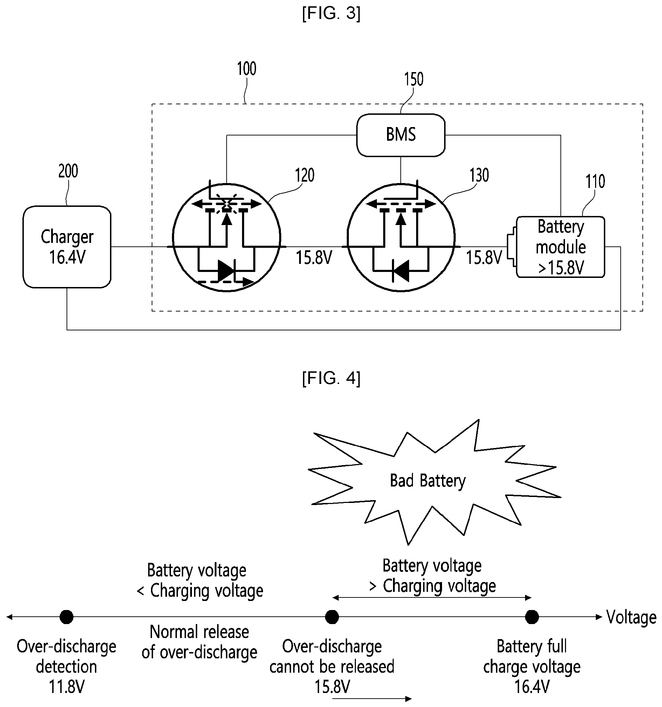

Next, referring to FIGS. 2 and 3, a description will be given of how battery pack 100 according to an embodiment of the present disclosure operates in the over-discharge prevention mode.

FIG. 2 is a drawing illustrating the battery pack according to the embodiment of the present disclosure operating in the normal mode, and FIG. 3 is a drawing illustrating the battery pack according to the embodiment of the present disclosure operating in the over-discharge prevention mode.

The normal mode may be a mode in which the battery module 110 is charged or discharged.

When the battery pack 100 operates in the normal mode, both the discharging switch 120 and the charging switch 130 may be turned on. The BMS 150 may control both the discharging switch 120 and the charging switch 130 to be turned on in the normal mode.

As in the example of FIG. 2, in the normal mode, the voltage of the battery module 110 may be 12 to 16.4 V, and the voltage of the charger 200 may be 16.4 V. That is, in the normal mode, the voltage of the charger 200 is higher than the voltage of the battery module 110. Therefore, in the normal mode, when the charger 200 is connected to the battery pack 100, charging occurs, and when the charger 200 is disconnected from the battery pack 100, discharging occurs.

The over-discharge prevention mode may be an operation mode for preventing the discharging of the battery module 110.

When the battery pack 100 operates in the over-discharge prevention mode, the discharging switch 120 may be off and the charging switch 130 may be on. The BMS 150 may control the discharging switch 120 to be off and the charging switch 130 to be on in the over-discharge prevention mode.

Since the discharging switch 120 is off, the discharge of the battery module 110 may be minimized.

The BMS 150 may detect the charging current while operating in the over-discharge prevention mode. The charging current refers to the current flowing through the power line, and the power line may be a line connecting the charger 200 and the battery module 110. Therefore, the charging current may be the current between the discharging switch 120 and the charging switch 130 or the current between the charging switch 130 and the battery module 110.

If the charger 200 is not connected and the discharging switch 120 is off, the charging current value may be 0 or close to 0. On the other hand, if the charger 200 is connected while the discharging switch 120 is kept off, a small amount of charging current may flow through the body diode of the discharging switch 120. Therefore, the BMS 150 may determine that the charger 200 is connected when the charging current is detected to be above a predetermined current value (e.g., 20 mA).

If the BMS 150 determines that the charger 200 is connected, it may control the discharging switch 120 to turn on. Accordingly, when the discharging switch 120 is switched from off to on, the battery module 110 may be charged by receiving voltage through the charger 200.

That is, the BMS 150 controls the normal mode when the charging current is greater than the predetermined current value, and accordingly, the battery module 110 can be charged. The BMS 150 can release the over-discharge prevention mode when the charging current is greater than the predetermined current value.

Table 1 below describes the entry/release conditions of the over-discharge prevention mode and the operation status of the charging/discharging switch.

**[Table 1]**

| **Condition** | **Charge Wait Operation** | |
|---|---|---|
| Over-discharge entry (11.8V or less) | DFET | OFF |
| | CFET | ON |
| Over-discharge release (Charging current >20mA) | DFET | ON |
| | CFET | ON |

In Table 1 above, DFET represents the discharging switch 120, and CFET represents the charging switch 130.

Referring to the Table 1, 'over-discharge entry' is a condition for entering the over-discharge prevention mode, and means an over-discharge condition. 'Over-discharge release' is a condition for releasing the over-discharge prevention mode.

When the condition for entering the over-discharge prevention mode is satisfied, the discharging switch 120 operates off, and the charging switch 130 operates on. When the condition for releasing the over-discharge prevention mode is satisfied, both the discharging switch 120 and the charging switch 130 operate on. When operating in the over-discharge prevention mode, the BMS 150 can control the discharging switch 120 to be off, and when releasing the over-discharge prevention mode, the BMS 150 can control the discharging switch 120 to be on.

In the Table 1, 'over-discharge entry' is described as the voltage of the battery module 110 being 11.8 V or less, and 'over-discharge release' is described as the charging current being greater than 20 mA, but this is only an example, and it is reasonable that it is not limited thereto.

In particular, the over-discharge condition that enters the over-discharge prevention mode is diverse. There may be one or more over-discharge conditions.

An example of the over-discharge condition is when the voltage of the battery module 110 is less than or equal to a normal minimum voltage level. Therefore, the over-discharge condition may include a case where the voltage of battery module 110 is less than or equal to a predetermined voltage.

For example, when the normal voltage of the battery module 110 is 12.0 to 16.4 V, the over-discharge condition may be when the voltage of the battery module 110 is less than or equal to 12.0 V. However, this is only an example, and it is reasonable that it is not limited thereto.

The voltage for determining whether the over-discharge condition occurs may be a minimum value of the normal voltage range of the battery module 110, or a value that adds or subtracts a predetermined value from the minimum value. For example, if the normal voltage range of the battery module 110 is 12.0 to 16.4 V, the voltage for determining whether the over-discharge condition occurs may be 12 V, (12+α) V, or (12-α) V. α may be a constant. For example, α may be 0.2, but this is only an example, and it is reasonable that it is not limited thereto.

In this specification, a first example of the over-discharge condition is assumed to be when the voltage of the battery module 110 is 11.8 V or lower. Therefore, the BMS 150 controls the over-discharge prevention mode when the voltage of the battery module 110 is 11.8 V or lower. Then, the BMS 150 can release the over-discharge prevention mode and control the discharging switch 120 to turn on when the charging current exceeds 20 mA.

However, the over-discharge prevention mode can be entered even when there is no actual over-discharge condition due to a momentary voltage drop of the battery module 110 or a voltage measurement error. In other words, the BMS 150 can detect the voltage of the battery module 110 as 11.8 V or lower even when the actual voltage of the battery module 110 exceeds 11.8 V. Therefore, even though the actual voltage of the battery module 110 exceeds 11.8 V, the BMS 150 can enter the over-discharge prevention mode and control the discharging switch 120 to be turned off.

For example, even though the actual voltage of the battery module 110 exceeds 15.8 V, the BMS 150 can control the discharging switch 120 to be turned off. In this case, even if the charger 200 is connected, the charging current may not flow due to the forward voltage drop (Vf) of a diode. That is, although the output voltage of the charger 200 is 16.4 V, the voltage between the discharging switch 120 and the charging switch 130 may be 15.8 V due to the forward voltage drop (Vf) of the diode. However, since the actual voltage of the battery module 110 is greater than 15.8 V, the charging current does not flow from the charger 200 to the battery module 110. Therefore, the condition for releasing the over-discharge prevention mode is not satisfied, and the BMS 150 continues to maintain the over-discharge prevention mode. Therefore, if the over-discharge prevention mode is entered even though the actual over-discharge condition is not satisfied, a problem occurs in which charging is not possible because the charging current does not flow. In addition, if the over-discharge prevention mode is entered even though the actual over-discharge condition is not satisfied, a problem occurs in which the mode is not released even if the charger 200 is connected.

FIG. 4 is a diagram showing a voltage relationship for explaining the above-described problem.

Referring to FIG. 4, the battery voltage is the voltage of the battery module 110, and the charging voltage may be the voltage between the discharging switch 120 and the charging switch 130. The battery full charge voltage is when the battery module 110 is fully charged, and the voltage at this time may be 16.4 V. If the battery voltage is 11.8 V or lower, it is detected as over-discharge and enters the over-discharge prevention mode. Then, if the battery voltage is lower than the charging voltage, the over-discharge prevention mode is normally released.

However, if the battery voltage exceeds 15.8 V and the over-discharge prevention mode is entered, the problem occurs that the over-discharge prevention mode is not released because the battery voltage is higher than the charging voltage.

In this case, if the over-discharge prevention mode is not released, the discharging switch 120 is kept off. Therefore, since the voltage charged in the battery module 110 does not flow toward the electronic device, the electronic device has a problem of being turned off when the adapter (not shown) is not connected.

Therefore, a method for releasing the over-discharge prevention mode is required when the over-discharge prevention mode is entered even though the actual over-discharge condition is not satisfied. The present disclosure provides a battery pack and an operating method thereof for resolving a malfunction problem when entering the over-discharge prevention mode even though the actual over-discharge condition is not satisfied.

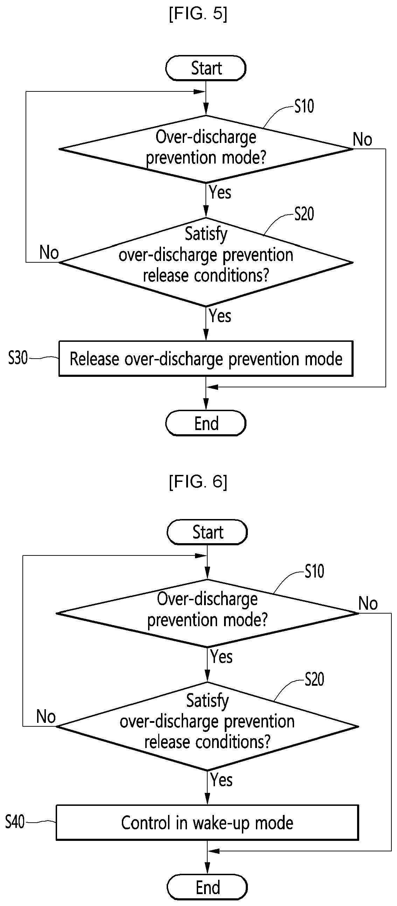

FIG. 5 is a flowchart illustrating an operation method of a battery pack according to a first embodiment of the present disclosure.

The BMS 150 can determine whether the battery module 110 is operating in the over-discharge prevention mode S10.

The BMS 150 can control the battery module 110 in the over-discharge prevention mode when it is determined that battery module 110 satisfies the over-discharge condition.

For example, the BMS 150 can determine that the over-discharge condition is not satisfied when the voltage of the battery module 110 exceeds a predetermined voltage (approximately 15.8 V).

The BMS 150 can determine whether the over-discharge prevention release condition is satisfied when operating in the over-discharge prevention mode S20.

There can be one or more the over-discharge prevention release conditions.

A first over-discharge prevention release condition is when the voltage of the battery module 110 exceeds a predetermined voltage. At this time, the predetermined voltage can be determined as a value obtained by subtracting the diode forward voltage drop value of the discharging switch 120 from the output voltage of the charger 200. For example, when the output voltage of the charger 200 is 16.4 V and the diode forward voltage drop value of the discharging switch 120 is 0.8 V, the predetermined voltage can be 15.8 V. That is, the first over-discharge prevention release condition is when the voltage of the battery module 110 exceeds 15.8 V. Accordingly, the BMS 150 can determine that the over-discharge prevention release condition is satisfied when the voltage of the battery module 110 exceeds the predetermined voltage, that is, 15.8 V. However, since 15.8 V is only an example, it is reasonable that it is not limited thereto.

A second over-discharge prevention release condition is when the output voltage from the charger 200 is less than the voltage of the battery module 110. The output voltage from the charger 200 may be a voltage between the charger 200 and the discharging switch 120. The BMS 150 may determine that the over-discharge prevention release condition is satisfied if the output voltage from the charger 200 is less than the voltage of the battery module 110.

A third over-discharge prevention release condition is when the voltage applied to the battery module 110 is less than the voltage of the battery module 110. The voltage applied to the battery module 110 may be a voltage between the charging switch 130 and the battery module 110. The BMS 150 may determine that the over-discharge prevention release condition is satisfied if the voltage applied to the battery module 110 is less than the voltage of the battery module 110.

A fourth over-discharge prevention release condition is when the output voltage from the charger 200 is different from the voltage applied to the battery module 110. The output voltage from the charger 200 may be the voltage between the charger 200 and the discharging switch 120, and the voltage applied to the battery module 110 may be the voltage between the charging switch 130 and the battery module 110. The BMS 150 may determine that the over-discharge prevention release condition is satisfied if the output voltage from the charger 200 is different from the voltage applied to the battery module 110.

A fifth over-discharge prevention release condition is when the charging current does not flow. The charging current may be the current flowing in the power line between the charger 200 and the battery module 110. The BMS 150 may determine that the over-discharge prevention release condition is satisfied if the charging current does not flow.

The first to fifth over-discharge prevention release conditions described above are intended to release the over-discharge prevention mode when the battery module 110 enters the over-discharge prevention mode even though the voltage of the battery module 110 is not actually in an over-discharge state.

The over-discharge prevention release condition may include at least one of the first to fifth over-discharge prevention release conditions described above. That is, the over-discharge prevention release condition may include at least one of the following: when the voltage of the battery module 110 exceeds a predetermined voltage; when the output voltage from the charger 200 connected to the battery pack 100 is lower than the voltage of the battery module 110; when the voltage applied to the battery module 110 is lower than the voltage of the battery module 110; when the output voltage from the charger 200 connected to the battery pack 100 is different from the voltage applied to the battery module 110; and when the charging current does not flow to the battery module 110.

In the past, the over-discharge prevention mode was released only when the charging current was generated through the charger 200 connection, but in the present disclosure, the over-discharge prevention mode can be released when at least one of the conditions described above is satisfied.

The BMS 150 can determine that the over-discharge prevention release condition is satisfied if any one of the first to fifth over-discharge prevention release conditions described above is satisfied.

The BMS 150 can release the over-discharge prevention mode when the over-discharge prevention release condition is satisfied S30.

That is, according to the first embodiment, the BMS 150 can immediately release the over-discharge prevention mode when the over-discharge prevention release condition is satisfied. Therefore, the BMS 150 can control the discharging switch 120 to be turned on when the over-discharge prevention release condition is satisfied.

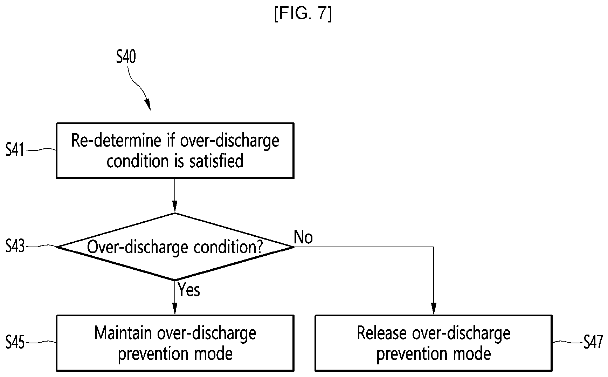

FIG. 6 is a flowchart illustrating an operation method of a battery pack according to a second embodiment of the present disclosure, and FIG. 7 is a flowchart specifying step S60 of FIG. 6.

The BMS 150 can determine whether the battery module 110 is operating in the over-discharge prevention mode S10.

The BMS 150 can determine whether the over-discharge prevention release condition is satisfied when operating in the over-discharge prevention mode S20.

S10 and S20 are the same as described in FIG. 5.

The BMS 150 can control the battery module 110 in wake-up mode if the over-discharge prevention release condition is satisfied S40.

The wake-up mode may be a mode that determines an operation mode by re-determining the state of the battery module 110. In the past, the wake-up mode was executed only when external power was applied, but according to the second embodiment of the present disclosure, the wake-up mode can be controlled even when the over-discharge prevention release condition is satisfied. That is, the battery voltage can be measured again through the wake-up mode to re-confirm whether the over-discharge condition is present and the operation mode can be determined.

The BMS 150 can re-determine whether the over-discharge condition is present in the wake-up mode S41.

The BMS 150 can determine whether the over-discharge condition is satisfied based on a result of re-determination S43.

That is, if the preset over-discharge prevention release condition is satisfied, the BMS 150 can re-determine whether the over-discharge condition is satisfied and determine whether to release the over-discharge prevention mode.

If the over-discharge condition is satisfied based on the result of re-determination, the BMS 150 can maintain the over-discharge prevention mode S45.

If the over-discharge condition is not satisfied based on the result of re-determination, the BMS 150 can release the over-discharge prevention mode S47.

If the over-discharge condition is not satisfied based on the result of re-determination, the BMS 150 can release the over-discharge prevention mode even if the charger 200 is not connected.

In this case, there is an advantage in that the operation stability is secured so that the operation mode of the battery pack 100 is more accurately controlled through re-determination of whether the battery module satisfies an over-discharge condition.

In the present disclosure, the battery pack 100 is named only for the convenience of explanation. That is, the battery pack 100 may also be named as a battery protection circuit or an over-discharge protection circuit.

The above description is merely an example of the technical idea of the present disclosure, and those with ordinary knowledge in the technical field to which the present disclosure belongs may make various modifications and variations without departing from the essential characteristics of the present disclosure.

Therefore, the embodiments disclosed in the present disclosure are not intended to limit the technical idea of the present disclosure, but to explain it, and the scope of the technical idea of the present disclosure is not limited by these embodiments.

The protection scope of the present disclosure should be interpreted by the claims below, and all technical ideas within the equivalent scope should be interpreted as being included in the scope of the rights of the present disclosure.

## Claims

1. A battery pack (100) comprising:
a battery module (110) including at least one battery cell;
a charging switch (130) connected to the battery module (110);
a discharging switch (120) connected to the charging switch (130); and
a BMS (150) configured to control the charging switch (130) and the discharging switch (120),
wherein the BMS (150) is configured to:
control the battery module (110) in an over-discharge prevention mode when it is determined that the battery module (110) satisfies an over-discharge condition, and
when a preset over-discharge prevention release condition is satisfied while operating in the over-discharge prevention mode, re-determine whether the battery module satisfies an over-discharge condition and determine whether to release the over-discharge prevention mode.

2. The battery pack (100) of claim 1, wherein the BMS (150) is configured to release the over-discharge prevention mode if the over-discharge condition is not satisfied as a result of the re-determination.

3. The battery pack (100) of claim 1 or claim 2, wherein the BMS (150) is configured to release the over-discharge prevention mode even if a charger (200) is not connected if the over-discharge condition is not satisfied as a result of the re-determination.

4. The battery pack (100) of any one of preceding claims, wherein the BMS (150) is configured to determine that the over-discharge prevention release condition is satisfied when a voltage of the battery module (110) exceeds a predetermined voltage.

5. The battery pack (100) of any one of preceding claims, wherein the BMS (150) is configured to determine that the over-discharge prevention release condition is satisfied if an output voltage from a charger (200) connected to the battery pack (100) is less than a battery voltage of the battery module (110).

6. The battery pack (100) of any one of preceding claims, wherein the BMS (150) is configured to determine that the over-discharge prevention release condition is satisfied if a voltage applied to the battery module (110) is less than a battery voltage of the battery module (110).

7. The battery pack (100) of any one of preceding claims, wherein the BMS (150) is configured to determine that the over-discharge prevention release condition is satisfied if an output voltage from the charger (200) connected to the battery pack (100) and a voltage applied to the battery module (110) are different.

8. The battery pack (100) of any one of preceding claims, wherein the BMS (150) is configured to determine that the over-discharge prevention release condition is satisfied when no charging current flows to the battery module (110).

9. The battery pack (100) of any one of preceding claims, wherein the BMS (150) is configured to:
control the discharging switch (120) to off when operating in the over-discharge prevention mode, and
control the discharging switch (120) to on when releasing the over-discharge prevention mode.

10. The battery pack (100) of any one of preceding claims, wherein the BMS (150) is configured to determine that the over-discharge condition is not satisfied when a voltage of the battery module (110) exceeds a predetermined voltage.

11. An operating method of a battery pack (100), comprising:
operating a battery module (110) in a normal mode in which it is charged or discharged;
controlling the battery module (110) to an over-discharge prevention mode when it is determined that the battery module (110) satisfies an over-discharge condition;
re-determining whether the battery module satisfies an over-discharge condition when a preset over-discharge prevention release condition is satisfied while operating in the over-discharge prevention mode; and
determining whether to release the over-discharge prevention mode based on a result of the re-determination.

12. The operating method of a battery pack (100) of claim 11, further comprising:
releasing the over-discharge prevention mode if the over-discharge condition is not satisfied as a result of the re-determination.

13. The operating method of a battery pack (100) of claim 11 or claim 12, wherein the releasing the over-discharge prevention mode comprises releasing the over-discharge prevention mode even if a charger (200) is not connected if the over-discharge condition is not satisfied as a result of the re-determination.

14. The operating method of a battery pack (100) of any one of claims 11 to 13, wherein
the over-discharge prevention release condition includes at least one of:
when a voltage of the battery module (110) exceeds a predetermined voltage,
when an output voltage from a charger (200) connected to the battery pack (100) is less than a voltage of the battery module (110),
when a voltage applied to the battery module (110) is less than the voltage of the battery module (110),
when an output voltage from a charger (200) connected to the battery pack (100) and the voltage applied to the battery module (110) are different, and
when no charging current flows to the battery module (110).

15. The operating method of a battery pack (100) of any one of claims 11 to 14, further comprising:
determining that the over-discharge condition is not satisfied when a voltage of the battery module (110) exceeds a predetermined voltage as a result of the re-determination.
